# EUROPEAN PATENT APPLICATION

(11) **EP 4 811 975 A1**
(43) Date of publication of application: **23.09.2026**
(21) Application number: 25899755.0
(22) Date of filing: 20.05.2025
(51) Int. Cl.: H10F 77/20

(54) **HBC CELL, BATTERY ASSEMBLY, AND PHOTOVOLTAIC SYSTEM**

(30) Priority: 03.12.2024 CN 202422975706 U
(71) Applicant: Zhejiang Aiko Solar Technology Co., Ltd, Jinhua, Zhejiang 322000 (CN)
(72) Inventor: WEI, Peicheng, Jinhua, Zhejiang 322000 (CN); QIU, Kaifu, Jinhua, Zhejiang 322000 (CN); WANG, Yongqian, Jinhua, Zhejiang 322000 (CN); CHEN, Gang, Jinhua, Zhejiang 322000 (CN)
(74) Representative: EP&C
(86) International application number: PCT/CN2025/096114
(87) International publication number: WO 2026/118387

(57) **Abstract**

The present disclosure is applicable to the field of photovoltaic technology, and provides an HBC cell, a cell assembly and a photovoltaic system. The HBC cell includes: a silicon substrate, first regions and second regions being arranged on a backlight surface of the silicon substrate, and the first regions and the second regions being arranged alternately; wherein a first polarity polysilicon layer is provided in each first region, a second polarity amorphous silicon layer is provided in each second regions, a TCO film layer is covered on both of the first regions and the second regions, an isolation trench is provided in the TCO film layer at each position adjacent to the first region and the second region, and the isolation trench passes through the TCO film layer; and at least a first TCO residue group and a second TCO residue group adjacent to each other are provided in each isolation trench, the first TCO residue group includes a plurality of first TCO residue square rings arranged adjacent to each other in an extension direction of the isolation trench, the second TCO residue group includes a plurality of second TCO residue square rings arranged adjacent to each other in the extension direction of the isolation trench, and adjacent corners of the first TCO residue square rings and the second TCO residue square rings are staggered from each other.

## Description

### Priority Information

The present disclosure claims priority to Chinese Patent Application No. 202422975706.1, filed to the China National Intellectual Property Administration on December 03, 2024 and entitled "HBC Cell, Cell Assembly and Photovoltaic System", which is incorporated herein by reference in its entirety.

### Technical Field

The present disclosure belongs to the field of photovoltaic technology, and in particular, to a Heterojunction Back Contact (HBC) cell, a Cell Assembly, and a photovoltaic system.

### Background

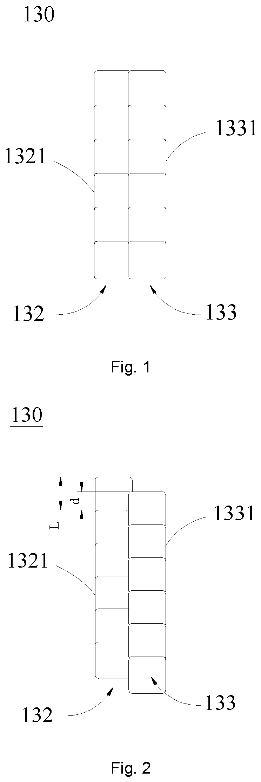

Existing HBC (heterojunction back contact) solar cell isolation trenches typically achieve isolation using two or more aligned and overlapping laser passes. The original intention of such a design is to ensure the reliability and thoroughness of the isolation trenches, so as to prevent p-n junctions on front and back faces of a cell from being short-circuited in certain regions. However, this overlapping laser isolation method has the following disadvantages:
when two or more laser passes are aligned and overlapped, the laser energy density in the overlapping region will increase significantly, as shown in Fig. 1, thereby resulting in thermal damage and structural damage to the material of the cell, reducing the mechanical performance of the cell, increasing the defect density of the material, and affecting the electrical performance of the cell; and laser damage may also increase recombination centers on the cell surface, resulting in increase of dark saturation current density (J02). Due to the laser damage and conductive paths in the overlapping region, current-voltage characteristics of the cell may be affected, resulting in a reduction in fill factor (FF). In the case of instability of the laser, transparent conductive oxide (TCO) may remain at fixed positions. These residual TCOs are aligned with and connected to each other to form a conductive path that connects p-n junctions, resulting in a short circuit which can seriously degrade the performance of the cell and even make the cell completely inoperative.

### Summary

The present disclosure provides an HBC cell, a cell assembly and a photovoltaic system, aiming to solve the problem of short circuit caused by alignment and connection of residual TCO film layer.

The present disclosure is implemented as follows: an HBC cell, including:
a silicon substrate, the silicon substrate having a backlight surface and a light-facing surface which are oppositely arranged, where the backlight surface of the silicon substrate is provided with first regions and second regions, and the first regions and the second regions are arranged alternately;
where a first polarity polysilicon layer is provided in each first regions, a second polarity amorphous silicon layer is provided in each second regions, a Transparent Conductive Oxide (TCO) film layer is covered on both of the first regions and the second regions, an isolation trench is provided in the TCO film layer at each position adjacent to the first region and the second region, and the isolation trench passes through the TCO film layer; and
where at least a first TCO residue group and a second TCO residue group adjacent to each other are provided in each isolation trench, the first TCO residue group includes a plurality of first TCO residue square rings arranged adjacent to each other in an extension direction of the isolation trench, the second TCO residue group includes a plurality of second TCO residue square rings arranged adjacent to each other in the extension direction of the isolation trench, and adjacent corners of the first TCO residue square rings and the second TCO residue square rings are staggered from each other.

Optionally, the isolation trench is arranged at a position in the first region close to the second region.

Optionally, adjacent edges of the first TCO residue square ring and the second TCO residue square ring have a same length.

Optionally, a length of the adjacent edges of the first TCO residue square ring and the second TCO residue square ring is L, and a distance between the adjacent corners of the first TCO residue square ring and the second TCO residue square ring is d, where 0.05L≤d≤0.5L.

Optionally, a length of an edge of the first TCO residue square ring perpendicular to the extension direction of the isolation trench is D1, and a length of an edge of the second TCO residue square ring perpendicular to the extension direction of the isolation trench is D2, where D1<D2.

Optionally, 0.05D2≤D1≤0.5D2.

Optionally, an area of the first TCO residue group is less than an area of the second TCO residue group.

Optionally, an area of the first TCO residue group is 50% to 95% of an area of the second TCO residue group.

The present disclosure further provides a cell assembly, including the described HBC cell.

The present disclosure further provides a photovoltaic system, including the described cell assembly.

Beneficial effects achieved by the present disclosure are: isolation trenches are provided in the TCO film layer, first TCO residue square rings and second TCO residue square rings are provided in each isolation trench, and corners of the first TCO residue square rings and the second TCO residue square rings are staggered from each other; and even if partial connection is formed in a manufacturing process, it is not easy to form a complete conductive path in a p-n junction region, thereby greatly reducing the risk of short circuit of a cell.

### Brief Description of the Drawings

Fig. 1 is a schematic structural top view of an isolation trench provided in the related art;
Fig. 2 is a schematic structural top view of an isolation trench provided according to the present disclosure;
Fig. 3 is another schematic structural top view of an isolation trench provided according to the present disclosure; and
Fig. 4 is a schematic structural diagram of an HBC cell provided according to the present disclosure.

Description of reference signs:
100. HBC cell; 110. First region; 111. Tunneling oxide layer; 112. First polarity polysilicon layer; 113. Phosphosilicate glass layer; 120. Second region; 121. First passivation layer; 122. Second polarity amorphous silicon layer; 130. TCO film layer; 131. Isolation trench; 132. First TCO residue group; 1321. First TCO residue square ring; 133. Second TCO residue group; 1331. Second TCO residue square ring; 140. Second passivation layer; 150. Anti-reflection layer.

### Detailed Description of the Embodiments

In order to make objects, technical solutions and advantages of the present disclosure clearly understood, hereinafter, the present disclosure will be further described in detail in conjunction with the accompanying drawings and embodiments. Examples of the embodiments will be illustrated in the accompanying drawings, where throughout the description, same or similar reference numerals represent same or similar elements or elements with same or similar functions. The embodiments described below with reference to the accompanying drawings are illustrative, and are only intended to explain the present disclosure, and shall not be understood as limiting the present disclosure. In addition, it should be understood that the specific embodiments described herein are only used to explain the present disclosure, and are not intended to limit the present disclosure.

In the illustration of the present disclosure, it should be understood that orientation or positional relationships indicated by terms such as "length", "width", "upper", "lower", "left", "right", "horizontal", "top", "bottom", etc. are orientation or positional relationships based on those as shown in the accompanying drawings, are only used to facilitate the illustration of the present disclosure and to simplify the illustration, rather than indicating or implying that an apparatus or assembly referred to must have a specific orientation, and be constructed and operated in the specific orientation, and therefore said terms cannot be understood as limitation to the present disclosure.

In addition, terms "first" and "second" are only used for descriptive purposes, and cannot be understood as indicating or implying relative importance or implicitly indicating the number of indicated technical features. Thus, features defined by "first" and "second" may explicitly or implicitly include one or more of said features. In the illustration of the present disclosure, the meaning of "a plurality of" is two or two and more, unless explicitly and specifically defined otherwise.

In the illustration of the present disclosure, it should be noted that unless specified and limited otherwise, the terms "mount", "connect to", and "connecting" should be understood broadly, and for example, may be fixed connection, and may also be detachable connection, or integral connection; may be mechanical connection, and may also be electrical connection, or may communicate with each other; and may be direct connection, and may also be indirect connection by means of an intermediate medium, and may also be interior communication between two elements, or interaction relationship between two elements. For a person of ordinary skill in the art, specific meanings of the described terms in the present disclosure could be understood according to specific situations.

In the present disclosure, unless explicitly specified or limited otherwise, a first feature being "above" or "below" a second feature may be the first feature and the second feature being in direct contact, or the first feature and the second feature being not in direct contact but being in contact with each other via another feature therebetween. Furthermore, a first feature being "over", "above", or "on" a second feature includes the first feature being directly above or obliquely above the second feature, or merely mean that the first feature having a horizontal height higher than that of the second feature. The first feature being "below", "beneath" or "under" the second feature includes the first feature being directly below or obliquely below the second feature, or merely mean that the first feature having a horizontal height lower than that of the second feature.

The following disclosure provides many different embodiments or examples for implementing different structures of the present disclosure. In order to simplify the disclosure content of the present disclosure, specific examples of components and arrangements are described below. Of course, they are merely examples, and the purpose thereof is not intended to limit the present disclosure. In addition, the present disclosure may repeat reference numerals and/or reference letters in different examples, and such repetition is for the purpose of simplicity and clarity, which does not in itself indicate a relationship between the various embodiments and/or arrangements discussed. In addition, examples of various specific processes and materials are provided in the present disclosure, but a person of ordinary skill in the art can recognize applications of other processes and/or usage of other materials.

In the present disclosure, isolation trenches are provided in a TCO film layer, first TCO residue square rings and second TCO residue square rings are provided in each isolation trench, and corners of the first TCO residue square rings and the second TCO residue square rings are staggered from each other; and even if partial connection is formed in a manufacturing process, it is not easy to form a complete conductive path in a p-n junction region, thereby greatly reducing the risk of short circuit of a cell.

### Embodiment I

Refer to Fig. 2 to Fig. 4, the present embodiment provides an HBC cell 100, including:
a silicon substrate, the silicon substrate having a backlight surface and a light-facing surface which are oppositely arranged, where first regions 110 and second regions 120 are arranged on the backlight surface of the silicon substrate, and the first regions 110 and the second regions 120 are arranged alternately;
where a first polarity polysilicon layer 112 is provided in each first regions 110, a second polarity amorphous silicon layer 122 is provided in the second regions 120, a TCO film layer 130 is covered on both of the first regions 110 and the second regions 120, an isolation trench 131 is provided in the TCO film layer at each position adjacent to the first region 110 and the second region 120, and the isolation trench 131 passes through the TCO film layer 130; and
where at least a first TCO residue group 132 and a second TCO residue group 133 adjacent to each other are provided in each isolation trench 131, the first TCO residue group 132 includes a plurality of first TCO residue square rings 1321 arranged adjacent to each other in an extension direction of the isolation trench 131, the second TCO residue group 133 includes a plurality of second TCO residue square rings 1331 arranged adjacent to each other in the extension direction of the isolation trench 131, and adjacent corners of the first TCO residue square rings 1321 and the second TCO residue square rings 1331 are staggered from each other.

The silicon substrate has two major surfaces, i.e. the light-facing surface and the backlight surface. The light-facing surface is directly facing sunlight, while the backlight surface is on the other side. The two surfaces are oppositely arranged.

Two different regions, i.e. the first regions 110 and the second regions 120, are arranged on the backlight surface of the silicon substrate, the two regions are arranged alternately, and the first regions 110 do not overlap with the second regions 120. Specifically, several first regions 110 and several second regions 120 are arranged alternately along a first direction, and the first regions 110 and the second regions 120 both extend along a second direction, the second direction intersecting with the first direction. The first regions 110 and the second regions 120 may be alternately arranged along a transverse direction of the silicon substrate and both extend along a longitudinal direction, that is, the first direction may be the transverse direction of a back contact cell, and the second direction may be the longitudinal direction of the back contact cell, and the two directions are perpendicular to each other. Certainly, in other embodiments, the first direction and the second direction may also be other directions, for example, the two directions may be diagonal directions of the silicon substrate, which is not specifically limited herein. The first regions 110 do not overlap with the second regions 120, and the first regions 110 are adjacent to the second regions 120.

The first polarity polysilicon layer 112 is arranged in the first region 110, and the second polarity amorphous silicon layer 122 is arranged in the second region 120; the first polarity polysilicon layer 112 and the second polarity amorphous silicon layer 122 have different polarities. Specifically, the first polarity polysilicon layer 112 may be a p-type polysilicon layer, and the second polarity amorphous silicon layer 122 is an n-type amorphous silicon layer; or the first polarity polysilicon layer 112 may be an n-type polysilicon layer, and the second polarity amorphous silicon layer 122 may be a p-type amorphous silicon layer. The first polarization polysilicon layer 112 and the second polarization amorphous silicon layer 122 form regions with different electrical characteristics, and support formation of p-n junctions and separation of carriers.

The TCO film layer 130 covers the first polarity polysilicon layer 112 and the second polarity amorphous silicon layer 122, the TCO film layer 130 is conductive, the isolation trench 131 is arranged at a position adjacent to the first region 110 and the second region 120, and the isolation trench 131 passes through the TCO film layer, which prevents electrical connection between the first regions 110 and the second regions 120 through the TCO film layer 130, and avoids a short circuit between p-n junction regions.

It can be understood that, the first regions 110 and the second regions 120 are alternately arranged, and the position adjacent to the first region 110 and the second region 120 may specifically be a position in the first region 110 close to the second region 120, and may also be a position in the second region 120 close to the first region 110, which is not limited herein.

The isolation trench 131 is formed in the TCO film layer by means of irradiation of two or more laser passes, and the laser irradiation is usually performed in a dot-matrix manner, that is, the TCO film layer is irradiated by a series of laser spots. Upon irradiation of each laser spot, a light spot is formed, and an annular TCO residue is formed around the light spot. This is because, in the laser irradiation process, the laser energy evaporates or melts a part of the TCO film layer, and the surrounding TCO film layer forms an annular residue due to not being heated evenly. The isolation trench 131 is formed by irradiation of two or more laser passes, each laser pass includes several parallel laser spots, that is, at least two laser passes are formed along a width direction of the isolation trench 131, and each laser pass is irradiated along the extension direction of the isolation trench 131. When the isolation trench 131 is formed by irradiation of several laser passes, several TCO residue groups remain in the isolation trench 131, and at least the first TCO residue group 132 and the second TCO residue group 133 adjacent to each other are provided in the isolation trench 131. Laser irradiation dots are densely arranged, and adjacent annular TCO residues are pressed against each other, such that original annular residues gradually become a square ring shape.

It can be understood that, the square rings formed by the TCO residues are substantially square in shape, and the square rings are formed by adjacent annular TCO residues being pressed against each other, thus arc-shaped lines or arc-shaped bends may exist at some positions.

By adjusting the arrangement of the laser irradiation points, corners of adjacent TCO residue square rings at an intersection of the isolation trench 131 are staggered from each other. This staggered design results in intersection of only three adjacent light spots, rather than four light spots, at an intersection of corners of the TCO residue square rings. On one hand, due to the staggered corners, the irradiated light spots thereof are no longer aligned in parallel, which reduces the overlapping of four adjacent light spots, greatly reduces the overlapping region of adjacent light spots in the laser process, and reduces the damage to the laser light spots. On the other hand, due to the staggered corners, the residual first TCO residue square rings 1321 and second TCO residue square rings 1331 are not likely to form a complete and continuous conductive path therebetween in the width direction of the isolation trench 131. Such a design reduces the conductive connection in the overlapping region, thereby reducing the risk of short circuit and greatly reducing the possibility of short circuit in the p-n junction regions. Even if some deviation occurs in a manufacturing process, a continuous conductive path is also not easily formed between adjacent residue square rings, thereby ensuring normal operation and high efficiency of the cell.

In this embodiment, corners of the first TCO residue square rings 1321 and the second TCO residue square rings 1331 are staggered from each other, thus even if partial connection is formed in the manufacturing process, it is not easy to form a complete conductive path in a p-n junction region, thereby greatly reducing the risk of short circuit of the cell.

The first TCO residue group 132 and the second TCO residue group 133 are adjacent along the width direction of the isolation trench 131.

In some embodiments, the isolation trench 131 is arranged at a position in the first region 110 close to the second region 120.

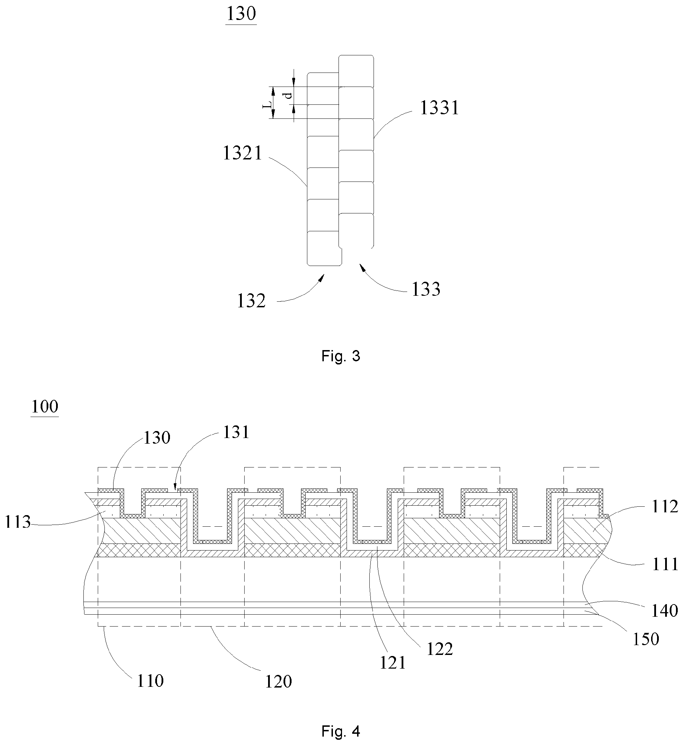

As shown in Fig. 4, in each first region 110, a tunneling oxide layer 111, the first polarity polysilicon layer 112, a phosphosilicate glass layer 113, a first passivation layer 121, and the second polarity amorphous silicon layer 122 are sequentially stacked; in each second region 120, the first passivation layer 121 and the second polarity amorphous silicon layer 122 are sequentially stacked; and the TCO film layer 130 is covered on the second polarity amorphous silicon layer 122 in the first regions 110 and the second regions 120. A second passivation layer 140 and an anti-reflection layer 150 may be further sequentially stacked on the front surface of the silicon substrate. The stacking arrangement in this embodiment refers to a position relationship between the layers, and does not exclude the case that other functional layers are further arranged between the layers.

Generally, a processing sequence thereof is as follows: first, the tunneling oxide layer 111, the first polarity polysilicon layer 112 and the phosphosilicate glass layer 113 are sequentially stacked on the backlight surface of the silicon substrate, then the tunneling oxide layer 111, the first polarity polysilicon layer 112 and the phosphosilicate glass layer 113 stacked in the second regions 120 are removed by etching, and then the first passivation layer 121, the second polarity amorphous silicon layer 122 and the TCO film layer 130 are sequential stacking in each second region 120. The first region 110 is not etched and has a larger number of stacked layers, and the distance between the TCO film layer 130 in the first region 110 and the front surface of the silicon substrate is larger than the distance between the TCO film layer 130 in the second region 120 and the front surface of the silicon substrate. The isolation trench 131 is provided at a position in the first region 110 close to the second region 120, such that the processing operation is more convenient, so as to better ensure the isolation effect between the first region 110 and the second region 120.

### Embodiment II

Refer to Figs. 2-4, in some embodiments, adjacent edges of the first TCO residue square ring 1321 and the second TCO residue square ring 1331 have the same length.

As adjacent edges of the first TCO residue square ring 1321 and the second TCO residue square ring 1331 have the same length, they can be arranged regularly along the extension direction of the isolation trench 131, thereby simplifying the manufacturing process, and also improving the repeatability and consistency of the process. If adjacent edges of the first TCO residue square ring 1321 and the second TCO residue square ring 1331 have different lengths, four corners may be aligned at certain positions, thereby increasing the risk of short circuit. By ensuring that the side lengths of the residue square rings are the same, alignment of four corners can be better avoided in the design and manufacturing process of the isolation trench 131, and the possibility of a short circuit is reduced.

In some embodiments, a length of adjacent edges of the first TCO residue square ring 1321 and the second TCO residue square ring 1331 is L, and a distance between adjacent corners of the first TCO residue square ring 1321 and the second TCO residue square ring 1331 is d, where 0.05L≤d≤0.5L.

The distance d between adjacent corners of the first TCO residue square ring 1321 and the second TCO residue square ring 1331 may be along the extension direction of L, a distance between an upper corner of the first TCO residue square ring 1321 and an upper corner of the second TCO residue square ring 1331 as shown in Fig. 2, or may be a distance between an upper corner of the first TCO residue square ring 1321 and a lower corner of the second TCO residue square ring 1331 as shown in Fig. 3.

When the distance d between adjacent corners is larger than 0.05L, alignment of four corners of four adjacent TCO residue square rings can be effectively avoided at the intersection of the isolation trench 131. Alignment of four corners increases the risk of short circuit, while the minimum value of d ensures that there is sufficient distance between the corners, reducing the risk of short circuit. Moreover, since the first TCO residue square ring 1321 and the second TCO residue square ring 1331 are in continuous adjacent contact, 0.5L is a maximum distance that can be reached between adjacent corners of the first TCO residue square ring 1321 and the second TCO residue square ring 1331.

It can be appreciated that 0.05L≤d≤0.5L can be achieved in the manufacturing process by precisely controlling the position and spacing of the laser irradiation points.

### Embodiment III

Refer to Fig. 2 to Fig. 4, in some embodiments, a length of an edge of the first TCO residue square ring 1321 perpendicular to the extension direction of the isolation trench 131 is D1, and a length of an edge of the second TCO residue square ring 1331 perpendicular to the extension direction of the isolation trench 131 is D2, where D1<D2.

The edges perpendicular to the extension direction of the isolation trench 131 are adjacent edges perpendicular to the first TCO residue square ring 1321 and the second TCO residue square ring 1331. In one TCO residue square ring, there are two edges which are perpendicular to the extension direction of the isolation trench, have equal lengths and are oppositely arranged.

The design of D1<D2 enables the overlapping area of the first TCO residue square ring 1321 and the second TCO residue square ring 1331 at the intersection of the isolation trench 131 to be smaller. Even if three adjacent residue square rings are overlapped, since the overlapping area is small, the formed conductive path is very limited, thereby greatly reducing the possibility of short circuit.

In some embodiments, 0.05D2≤D1≤0.5D2.

By setting D1 to be 0.05 times to 0.5 times of D2, the compactness and high efficiency of the cell structure can be maintained while ensuring the isolation effect. If D1 is too small, the first TCO residue square ring 1321 may be too fine, affecting the stability and conductivity thereof in the cell structure; and if D1 is too large, the overlapping area may be increased, which affects the isolation effect.

### Embodiment IV

Refer to Figs. 2-4, in some embodiments, the area of the first TCO residue group 132 is less than the area of the second TCO residue group 133.

The first TCO residue group 132 is formed by residue of the TCO film layer 130 by irradiation of a first laser pass, and the second TCO residue group 133 is formed by residue of the TCO film layer 130 by irradiation of a second laser pass. After irradiation of the first laser pass is completed, irradiation of the second laser pass is performed.

The first laser pass and the second laser pass are both irradiated in the extension direction of the isolation trench 131, and each laser pass includes several laser spots arranged in the same direction, so as to form several continuous light spots and converge to form a strip-shaped light spot. The first laser pass forms a first strip-shaped light spot, and the second laser pass forms a second strip-shaped light spot. Generally, when the first laser pass and the second laser pass have the same intensity and the laser spots also have the same spacing distance, the areas of the first strip-shaped light spot and the second strip-shaped light spot are the same. The first strip-shaped light spot and the second strip-shaped light spot partially overlap, and at the overlapping position, the second TCO residue group 133 occupies a part of the original position of the first TCO residue group 132, such that the area of the first TCO residue group 132 is reduced.

The area of the first TCO residue group 132 is smaller than the area of the second TCO residue group 133, thus even if three adjacent residue square rings overlap at the intersection of the isolation trench 131, the formed conductive path is very limited, thereby further reducing the possibility of the conductive path and reducing the risk of short circuit.

In some embodiments, the area of the first TCO residue group 132 is 50% to 95% of the area of the second TCO residue group 133.

The area of the first TCO residue group 132 is 50% to 95% of the area of the second TCO residue group 133, i.e., the overlapping region of the first strip-shaped light spot and the second strip-shaped light spot is 50% to 5%. When the overlapping region between the first strip-shaped light spot and the second strip-shaped light spot exceeds 50%, the laser damage increases, resulting in an increase in the dark saturation current density (J02), and a decrease in the fill factor (FF). J02 is an important parameter for measuring the recombination rate on the surface of a solar cell, and increase thereof can significantly reduce the open-circuit voltage (Voc) of the cell, thereby reducing the overall efficiency; and FF is an important parameter for measuring the output characteristics of the solar cell, and decrease thereof will directly affect the output power and efficiency of the cell. When the overlapping region between the first strip-shaped light spot and the second strip-shaped light spot is less than 5%, it is easy to cause incomplete removal of the TCO film layer 130, form an electrical path, short-circuit p-n junctions, and reduce the cell performance.

The content above merely relates to preferred embodiments of the present disclosure, and is not intended to limit the present disclosure. Any modifications, equivalent replacements, improvements and the like made within the spirit and principle of the present disclosure shall all fall within the scope of protection of the present disclosure.

## Claims

1. A Heterojunction Back Contact (HBC) cell, comprising:
a silicon substrate, the silicon substrate having a backlight surface and a light-facing surface which are oppositely arranged, wherein the backlight surface of the silicon substrate is provided with first regions and second regions, and the first regions and the second regions are arranged alternately;
a first polarity polysilicon layer provided in each first region, a second polarity amorphous silicon layer provided in each second region, a Transparent Conductive Oxide (TCO) film layer covered on both of the first regions and the second regions, an isolation trench provided in the TCO film layer at each position adjacent to the first region and the second region, wherein the isolation trench passes through the TCO film layer; and
at least a first TCO residue group and a second TCO residue group adjacent to each other provided in each isolation trench, wherein the first TCO residue group comprises a plurality of first TCO residue square rings arranged adjacent to each other in an extension direction of the isolation trench, the second TCO residue group comprises a plurality of second TCO residue square rings arranged adjacent to each other in the extension direction of the isolation trench, and adjacent corners of the first TCO residue square rings and the second TCO residue square rings are staggered from each other.

2. The HBC cell according to claim 1, wherein the isolation trench is arranged at a position in the first region close to the second region.

3. The HBC cell according to claim 1, wherein adjacent edges of the first TCO residue square ring and the second TCO residue square ring have a same length.

4. The HBC cell according to claim 3, wherein a length of the adjacent edges of the first TCO residue square ring and the second TCO residue square ring is L, and a distance between the adjacent corners of the first TCO residue square ring and the second TCO residue square ring is d, and 0.05L≤d≤0.5L.

5. The HBC cell according to claim 1, wherein a length of an edge of the first TCO residue square ring perpendicular to the extension direction of the isolation trench is D1, and a length of an edge of the second TCO residue square ring perpendicular to the extension direction of the isolation trench is D2, and D1<D2.

6. The HBC cell according to claim 5, wherein 0.05D2≤D1≤0.5D2.

7. The HBC cell according to claim 1, wherein an area of the first TCO residue group is less than an area of the second TCO residue group.

8. The HBC cell according to claim 7, wherein an area of the first TCO residue group is 50% to 95% of an area of the second TCO residue group.

9. A cell assembly, comprising the HBC cell according to any one of claims 1 to 8.

10. A photovoltaic system, comprising the cell assembly according to claim 9.
